# EUROPEAN PATENT SPECIFICATION

(11) **EP 0 514 602 B1**
(45) Date of publication and mention of the grant of the patent: **20.05.1998**
(21) Application number: 91307605.5
(22) Date of filing: 16.08.1991
(51) Int. Cl.: H01L 29/10, H01L 29/423, H01L 29/78, H01L 21/336

(54) **MOSFET channel structure and method of fabrication**
MOSFET-Kanalstruktur und Verfahren zur Herstellung
Structure de canal MOSFET et sa méthode de fabrication

(30) Priority: 21.05.1991 JP 116155/91
(43) Date of publication of application: 25.11.1992
(73) Proprietor: SHARP KABUSHIKI KAISHA, Osaka-shi, Osaka-fu 545 (JP)
(72) Inventor: Adan, Alberto Oscar, Tenri-shi, Nara-ken (JP)
(74) Representative: Brown, Kenneth Richard

(56) References cited:
- EP-A- 0 083 447
- US-A- 4 597 824
- US-A- 4 808 544
- INTERNATIONAL ELECTRON DEVICES MEETING 1985 WASHINGTON, DC DECEMBER 1-4, 1985 pages 230 - 233; CHRISTOPHER F. CODELLA ET AL:'HALO DOPING EFFECTS IN SUBMICRON DI-LDD DEVICE DESIGN?
- IEEE ELECTRON DEVICE LETTERS. vol. 11, no. 6, June 1990, NEW YORK US pages 253 - 255; JAMES R. PFIESTER ET AL: 'A Selectively Deposited Poly-Gate ITLDD Process with Self-Aligned LDD/Channel Implantation'
- IBM TECHNICAL DISCLOSURE BULLETIN. vol. 22, no. 6, November 1979, NEW YORK US pages 2292 - 2293; R. C. VARSHNEY: 'DOUBLE POLYSILICON DEPLETION-MODE MOS TRANSISTOR STRUCTURE'

## Description

### BACKGROUND OF THE INVENTION

### 1. Field of the Invention

The present invention relates to a process for fabricating a semiconductor device and, more particularly to a process for fabricating a Metal Oxide Semiconductor Field Effect Transistor (called hereunder, MOSFET) having a submicron channel length.

### 2. Description of the Prior Art

Recently, MOS transistors have been rapidly scaled down, involving shortened channel lengths thereof. This results in severe degradation of electrical characteristics of MOS transistors due to threshold voltage lowering and mobility degradation when the channel length becomes comparable to the source and drain regions depletion layer width. These effects are known as "short-channel degradation", and are a serious limitation for further device scaling.

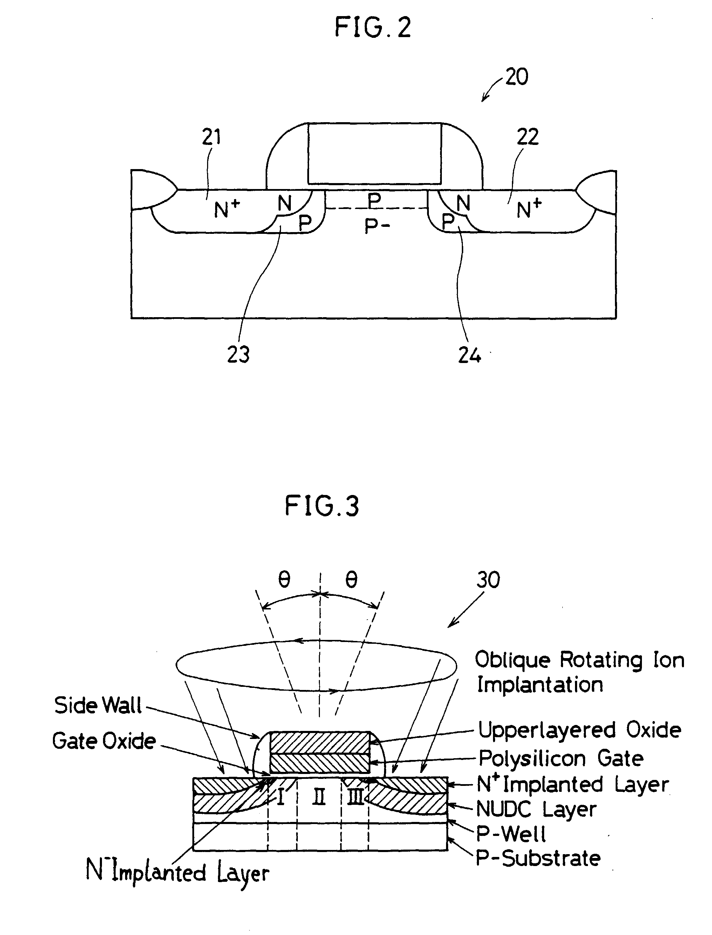

Some approaches for overcoming the above effects are known. One of these approaches adopts the so-called "halo" or "pocket" deep implantation to provide highly doped regions 23 and 24 near the respective junctions of source 21 and drain 22 of a MOS transistor 20, as shown in FIG. 2 (C.F.Codella and S.Ogura, "Halo doping effects in submicron DI-LDD device design", IEDM Tech. Dig. (1985), 230 and US-A-4 597 824.) However, the depth and lateral spread of this implantation may be limited in sub-half micrometer channel length transistors, and in addition, a higher doping concentration at the drain junction increases the junction parasitic capacitance degrading device speed.

Another approach uses oblique rotating ion implantation to form a non-uniformly doped channel of a MOS transistor 30, as shown in FIG. 3 (Y. Okumura, et al.: "A Novel Source-to-Drain Nonuniformly doped Channel (NUDC) MOSFET for high current drivability and threshold voltage controllability", IEDM Tech. Dig. (1990), 391). According to this technique, the doping concentration is higher near the source and drain, which reduces the widening of the depletion region, and at the same time, the doping concentration in the middle of the channel is reduced to improve the carrier mobility. The limitation of this technique is that in order to penetrate about 1/3 of the channel length, a relatively large implantation angle (θ) and a relatively high energy are required. This results in: (i) higher concentration at the drain junction, degrading device speed; and (ii) difficult control of the channel middle region width, especially in sub-half micrometer devices.

### SUMMARY OF THE INVENTION

The present invention has been accomplished to overcome the foregoing problems of the prior art.

The present invention provides, in one aspect the process defined by claim 1 for fabricating a semiconductor device and in another aspect the semiconductor device defined by claim 5. The subclaims 2 to 4 and 6 are directed to embodiments of the present invention.

### BRIEF DESCRIPTION OF THE DRAWINGS

Fig. 1 is a view illustrating a process according to an embodiment of the present invention;
Fig. 2 is a view illustrating a structure of a prior art MOS transistor; and
Fig. 3 is a view illustrating a structure of another prior art MOS transistor.

### DETAILED DESCRIPTION OF THE PREFERRED EMBODIMENT

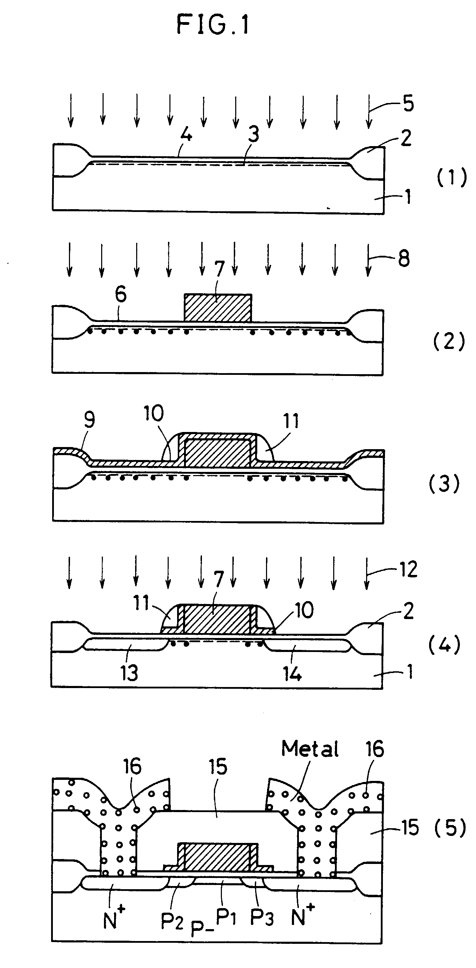

A preferred embodiment of the present invention will now be described in detail with reference to Fig. 1.
(a) Referring to Fig. 1(1), a field oxide 2 is first formed on a Si substrate 1 to provide an isolation region 2 and an active region 3. The field oxide 2 is formed to about 5000-6000 Å (10Å = 1nm) thick using the well-known LOCOS technique at a temperature, for example, 1050 °C in the presence of H₂ and O₂. Subsequently, a thin SiO₂ layer 4 is formed to about 200-300 Å thick over the active region 3 by thermal oxidation of silicon at, for example, 1050 °C in O₂ ambient, or a CVD process using, for example, SiH₄ and O₂, at 800-850 °C and 67 - 267 Pa (0.5-2.0 Torr).
(b) A first channel doping is performed by implanting P-type ions 5 such as B ions or In ions into the Si substrate 1 using the thin SiO₂ layer 4 as a screening layer. The implantation is effected orthogonally to the substrate 1 but shallowly, thereby defining the doping depth and the impurity atoms concentration at the center of the channel (P₁ in FIG. 1(5)). Conditions for the implantation are selected depending on the characteristics of an intended device. Usually the acceleration energy is set to about 30-40 keV; the dosage is set to about 1-5 x 10¹²cm⁻².
(c) The thin SiO₂ layer 4 is removed by, for example, wet etching (1% HF aqueous solution), and then as shown in FIG. 1(2), a gate oxide dielectric 6 is grown to a predetermined thickness by thermal oxidation. For example, in a 0.5 µm channel process, the gate oxide dielectric 6 is grown to about 100-130 Å thick by heating at about 900-1000 °C for 0.5-1 hour.
   Next, as shown in FIG. 1(2) a gate electrode 7 is formed in the following typical manner. A polysilicon layer is first deposited to about 1000-4000 Å thick by LPCVD process using, for example, SiH₄, at 600-650 °C and 67 Pa (0.5 Torr); subsequently the polysilicon layer is doped with N-type ions such as phosphorus ions (acceleration energy: 60-80 keV; dosage: 10¹⁵ cm⁻²) so as to lower the resistance of the layer, and the thus obtained polysilicon layer is patterned and etched by RIE technique (Cl₂ + O₂ + HBr, 20 mTorr) to form the gate electrode 7.
(d) Subsequently a second channel doping is performed by implanting P-type ions 8 such as B ions or In ions (acceleration energy: 30-40 keV, dosage: 10¹²-10¹³ cm⁻²), using the gate electrode 7 as a mask. The second channel doping together with the first channel doping defines the doping depth and the impurity atoms concentration at the extremes of the channel (P₂ and P₃ of FIG. 1(5)). The doping depth and the impurity atoms concentration can be optimized to reduce short-channel degradation.
(e) Referring to FIG. 1(3), a thin polysilicon layer 9 is deposited to about 200-500 Å thick by, for example, LPCVD process using SiH₄ or the like, at 600-650 °C and about 67 Pa (0.5 Torr).
(f) On the thin polysilicon 9, a SiO₂ layer is deposited to about 1000-2000 Å thick by, for example, CVD process using SiH₄ + O₂, at 800-900 °C.
(g) Referring to FIG. 1(4), the above SiO₂ layer and the polysilicon layer 9 are etched, while retaining a portion of them so as to form side walls on opposite sides of the gate electrode 7, the side walls consisting of gate electrode extensions 10 (the retained portion of the polysilicon layer 9) and the retained SiO₂ layer 11. The etching in this process may be performed as follows. First, the SiO₂ layer is etched by RIE technique (CHF₃ + CF₄ + Ar, 133 Pa (1 Torr)) to form the retained SiO₂ layer 11 near the gate electrode 7. Subsequently the polysilicon layer 9 is etched by RIE technique (Cl₂ + O₂ + HBr, 20 mTorr) to form the gate electrode extensions 10.
(h) As shown in FIG. 1(4), implantation of N-type ions 12 is performed using the side walls and the gate electrode as a mask to form a source region 13 and a drain region 14, followed by heat treatment. In the implantation there are used, for example, P ions or As ions as the N-type ions 12, with acceleration energy: 30-50 keV, dosage: 1-3 x 10¹⁵ cm⁻². The heat treatment is performed at about 800-850 °C for 0.5-1 hour.
(i) Referring to FIG. 1(5), another SiO₂ layer 15 as an isolation layer is deposited by, for example, CVD process, followed by heat treatment (850-950 °C for 0.5-1 hour). Then, contact holes are formed and filled with a metal layer 16 to form devices interconnection according to well-known techniques.

According to the process of the invention, a MOS transistor structure shown in FIG. 1(5) is obtained. By the first and second channel dopings the central portion (P₁ of FIG. 1(5)) is lightly doped so as to enhance the mobility, while the extreme portions (P₂ and P₃ of FIG. 1(5)) of the channel are heavily doped, thereby reducing the depletion areas of the source 13 and the drain 14. Such a non-uniform doping is shallowly performed so that the parasitic drain junction capacitance will not increase unnecessarily, whereby the device speed does not lower. Thus, the process of the present invention makes it possible to fabricate MOS transistors with a higher yield and low cost in a simpler manner than the prior art methods.

### EXAMPLE

A MOS transistor was fabricated according to the following process.
(a) A Si substrate was patterned with a resist and heated at 1000 °C for 2 hours under oxygen atmosphere to form an isolation region, which was constituted by a field oxide of about 6000 Å thick, and an active region. On the active region a thin SiO₂ layer was deposited to about 250 Å thick by CVD process using SiH₄ + O₂ at 850 °C.
(b) A first channel doping was performed by implanting B ions into the active region orthogonally to the substrate with acceleration energy: 30 keV, dosage: 10¹² cm⁻², using the thin SiO₂ layer as a screening layer.
(c) The thin SiO₂ layer was removed using 1% HF aqueous solution. Thereafter, a gate oxide dielectric was grown to 120 Å thick on the substrate by thermal oxidation (heating at 900 °C for 18 min under oxygen atmosphere).
   Next, a polysilicon layer was deposited to 2500 Å thick over the gate oxide dielectric by LPCVD process using SiH₄ at 600-650 °C, 0.5 Torr. The polysilicon layer was implanted with phosphorus ions (acceleration energy: 70 keV, dosage: 10¹⁵ cm⁻²) to be become N type. The polysilicon layer thus obtained was patterned and etched by RIE technique (Cl₂ + O₂ + HBr, 20 mTorr) to form a gate electrode.
(d) A second channel doping was performed by implanting B ions orthogonally to the substrate (acceleration energy: 30 keV, dosage: 10¹³ cm⁻²), using the gate electrode as a mask.
(e) A thin polysilicon layer was deposited to 350 Å thick by LPCVD process using SiH₄ at 620 °C, 67 Pa (0.5 Torr), to form a thin polysilicon layer.
(f) A SiO₂ layer was deposited to 1500 Å thick to cover the thin polysilicon layer by CVD process using SiH₄ + O₂ at 850 °C.
(g) The SiO₂ layer was etched but retained near the gate electrode by RIE technique (CHF₃ + CF₄ + Ar, 133 Pa (1 Torr)), then the thin polysilicon layer was also etched but retained near the gate electrode by RIE technique (Cl₂ + O₂ + HBr, 2,7 Pa (20 mTorr)) to form gate electrode extensions. Consequently side walls were formed.
(h) Arsenic ions were implanted ( acceleration energy : 40 KeV, dosage : 3 x 10¹⁵ cm⁻¹ ) to form the source and drain using the electrode and the side walls as a mask, followed by heat treatment at 800 °C for 1 hour.
(i) Another SiO₂ layer was deposited to 6000 Å thick by well-known process, followed by heat treatment at 900 °C for 0.5 hours. Contact holes were formed, then filled with metal to form device interconnections.

Thus, a MOS transistor having a half-micrometer channel length was obtained, which exhibited satisfactory electrical characteristics.

According to the process of the invention, a non-uniformly and lightly doped channel was formed. This results in reduced degradation of transistor characteristics by short-channel effects, increased effective mobility and drive current, and no increase of the parasitic drain junction capacitance. Thus, a MOS transistor having a sub-half micrometer channel length can be fabricated in a simplified manner with a high yield.

## Claims

1. A process for fabricating a semiconductor device having a non-uniformly and lightly-doped channel, comprising:
(a) forming on a silicon substrate (1) of a first conductivity type a field oxide (2) to provide an isolation region (2) and an active region (3), followed by forming a thin silicon oxide layer (4), which is substantially thinner than said field oxide, on said active region;
(b) performing a first channel doping by implanting ions (5) of the same first conductivity type as the silicon substrate, using said thin silicon oxide layer (4) as a screening layer;
(c) after removing said thin silicon oxide layer (4), forming a gate oxide dielectric (6) and then a gate electrode (7) thereon;
(d) performing a second channel doping by implanting ions (8) of said first conductivity type, using said gate electrode (7) as a mask;
(e) depositing a thin polysilicon layer (9), which is substantially thinner than said gate electrode (7), on the entire surface;
(f) depositing a silicon oxide layer so as to cover said thin polysilicon layer (9);
(g) etching said silicon oxide layer to form respective side walls (11) on opposite sides of said gate electrode (7), and then etching said thin polysilicon layer (9) using said side walls (11) as a mask to form gate electrode extensions (10) adjacent to the gate electrode; and
(h) implanting ions (12) of a second conductivity type using said side walls (11), gate electrode (7) and gate electrode extensions (10) as a mask, followed by heat treatment to provide source (13) and drain (14) regions, thereby forming on said substrate a first channel portion (P₁) including first conductivity type ions and corresponding to said gate electrode (7), second channel portions (P2, P3) having higher concentration of impurity than the first channel portion and corresponding respectively to said gate electrode extensions (10), and source and drain regions (13, 14), whereby the entire source and drain regions are laterally outside of the second channel portions.

2. A process according to claim 1, wherein said first conductivity type ions (5;8) are B ions or In ions.

3. A process according to claim 1, wherein said second conductivity type ions (12) are P ions or As ions.

4. A process according to any one of claims 1 to 3, wherein the retained portion of said thin polysilicon layer (9) which forms the gate electrode extension (10) is L-shaped in cross-section.

5. A semiconductor device having a non-uniformly and lightly-doped channel, comprising:
a silicon substrate (1) of a first conductivity type;
a gate oxide dielectric film (6) formed on the silicon substrate;
a gate electrode (7) formed on the gate oxide dielectric film;
gate electrode extensions (10) made of a respective thin polysilicon layer portion formed on the gate oxide dielectric film on opposite sides of the gate electrode (7), the gate electrode extensions (10) each extending from and contacting a respective edge of the gate electrode, the gate electrode extensions (10) being substantially thinner than the gate electrode; and
a channel region formed in the silicon substrate, said channel region having a first channel portion (P₁) located below the gate electrode (7) and doped with ions of said first conductivity type at a concentration higher than in the silicon substrate outside of the channel region and second channel portions (P2, P3) located respectively below the gate electrode extensions (10) and doped with ions of said first conductivity type at a concentration higher than in the first channel portion (P1), said silicon substrate (1) having outer portions where source and drain regions (13, 14) doped with ions of a second conductivity type are respectively formed, wherein the entire source and drain regions (13,14) are formed laterally outside of the entire second channel portions (P2, P3).

6. A semiconductor device according to claim 5, wherein each gate electrode extension (10) is L-shaped in cross-section.

## Patentansprüche

1. Verfahren zum Herstellen eines Halbleiter-Bauteils mit ungleichmäßig und leicht dotiertem Kanal, umfassend:
(a) Herstellen eines Feldoxids (2) von erstem Leitungstyp auf einem Siliziumsubstrat (1), um einen Isolierbereich (2) und einen aktiven Bereich (3) zu schaffen, gefolgt vom Herstellen einer dünnen Siliziumoxidschicht (4), die wesentlich dünner als das Feldoxid ist, auf dem aktiven Bereich;
(b) Ausführen eines ersten Kanaldotierungsvorgangs durch Implantieren von Ionen (5) vom selben ersten Leitungstyp wie dem des Siliziumsubstrats, wobei die dünne Siliziumoxidschicht (4) als Abschirmungsschicht verwendet wird;
(c) Herstellen eines Gateoxid-Dielektrikums (6) und dann einer Gateelektrode (7) auf diesem, nachdem die dünne Siliziumoxidschicht (4) entfernt wurde;
(d) Ausführen eines zweiten Kanaldotierungsvorgangs durch Implantieren von Ionen (8) des ersten Leitungstyps unter Verwendung der Gateelektrode (7) als Maske;
(e) Abscheiden einer dünnen Polysiliziumschicht (9), die wesentlich dünner als die Gateelektrode (7) ist, auf der gesamten Oberfläche;
(f) Abscheiden einer Siliziumoxidschicht in solcher Weise, dass die dünne Polysiliziumschicht (9) bedeckt wird;
(g) Ätzen der Siliziumoxidschicht zum Ausbilden jeweiliger Seitenwände (11) an entgegengesetzten Seiten der Gateelektrode (7) und anschließendes Ätzen dieser dünnen Polysiliziumschicht (9) unter Verwendung der Seitenwände (11) als Maske, um Gateelektroden-Verlängerungen (10) angrenzend an die Gateelektrode auszubilden; und
(h) Implantieren von Ionen (12) von zweitem Leitungstyp unter Verwendung der Seitenwände (11), der Gateelektrode (7) und der Gateelektroden-Verlängerungen (10) als Maske, gefolgt von einer Wärmebehandlung zum Erzeugen von Sourcebereichen (13) und Drainbereichen (14), um dadurch auf dem Substrat einen ersten Kanalabschnitt (P₁), der Ionen vom ersten Leitungstyp enthält und der Gateelektrode (7) entspricht, zweite Kanalabschnitte (P₂, P₃) mit höherer Fremdstoffkonzentration als im ersten Kanalabschnitt, die jeweils den Gateelektroden-Verlängerungen (10) entsprechen, sowie Source- und Drainbereiche (13, 14) herzustellen, wobei die gesamten Source- und Drainbereiche außerhalb der zweiten Kanalabschnitte liegen.

2. Verfahren nach Anspruch 1, bei dem die Ionen (5; 8) vom ersten Leitungstyp B-Ionen oder In-Ionen sind.

3. Verfahren nach Anspruch 1, bei dem die Ionen (12) vom zweiten Leitungstyp P-Ionen oder As-Ionen sind.

4. Verfahren nach einem der Ansprüche 1 bis 3, bei dem der verbliebene Teil der dünnen Polysiliziumschicht (9), der die Gateelektroden-Verlängerung (10) bildet, L-förmigen Querschnitt aufweist.

5. Halbleiter-Bauteil mit ungleichmäßig und leicht dotiertem Kanal, mit:
- einem Siliziumsubstrat (1) von erstem Leitungstyp;
- einem auf dem Siliziumsubstrat ausgebildeten, dielektrischen Gateoxidfilm (6);
- einer auf dem dielektrischen Gateoxidfilm ausgebildeten Gateelektrode (7);
- Gateelektroden-Verlängerungen (10) aus jeweiligen Abschnitten einer dünnen Polysiliziumschicht, die auf dem dielektrischen Gateoxidfilm an entgegengesetzten Seiten der Gateelektrode (7) ausgebildet sind;
- wobei sich die Gateelektroden-Verlängerungen (10) jeweils ausgehend von der Gateelektrode erstrecken und in Kontakt mit einer jeweiligen Kante derselben stehen, wobei die Gateelektroden-Verlängerungen wesentlich dünner als die Gateelektrode sind; und
- einem im Siliziumsubstrat ausgebildeten Kanalbereich mit einem ersten Kanalabschnitt (P₁), der unter der Gateelektrode (7) liegt und mit Ionen vom ersten Leitungstyp mit einer Konzentration über der im Siliziumsubstrat außerhalb des Kanalbereichs dotiert ist, und zweiten Kanalabschnitten (P₂, P₃), die jeweils unter den Gateelektroden-Verlängerungen (10) liegen und mit Ionen vom ersten Leitungstyp mit einer Konzentration über der im ersten Kanalabschnitt (P₁) dotiert sind, wobei das Siliziumsubstrat (1) äußere Abschnitte aufweist, in denen jeweils ein Sourcebereich (13) und ein Drainbereich (14) ausgebildet sind, die mit Ionen von einem zweiten Leitungstyp dotiert sind, wobei die gesamten Source- und Drainbereiche (13, 14) in Querrichtung außerhalb der gesamten zweiten Kanalabschnitte (P₂, P₃) ausgebildet sind.

6. Halbleiter-Bauteil nach Anspruch 5, bei dem jede Gateelektroden-Verlängerung (10) L-förmigen Querschnitt aufweist.

## Revendications

1. Procédé pour fabriquer un dispositif semi-conducteur ayant un canal dopé légèrement de manière non uniforme, comprenant les étapes suivantes :
(a) former sur un substrat de silicium (1) d'un premier type de conductivité un oxyde primaire (2) pour créer une région d'isolement (2) et une région active (3), puis former une mince couche d'oxyde de silicium (4), laquelle est substantiellement plus mince que ledit oxyde de champ, sur ladite région active ;
(b) effectuer un premier dopage de canal en implantant des ions (5) du même premier type de conductivité que le substrat en silicium, en utilisant ladite couche mince d'oxyde de silicium (4) comme couche d'écran ;
(c) après avoir retiré ladite couche mince d'oxyde de silicium (4), former un oxyde diélectrique de grille (6), puis une électrode de grille (7) par dessus ;
(d) effectuer un second dopage de canal en implantant des ions (8) dudit premier type de conductivité, en utilisant ladite électrode de grille (7) comme masque ;
(e) déposer une mince couche de polysilicium (9), laquelle est substantiellement plus mince que ladite électrode de grille (7), sur toute la surface ;
(f) déposer une couche d'oxyde de silicium de façon à couvrir ladite couche mince de polysilicium (9) ;
(g) décaper ladite couche d'oxyde de silicium pour former des parois latérales respectives (11) sur des côtés opposés de ladite électrode de grille (7), et puis décaper ladite couche mince de polysilicium (9) en utilisant lesdites parois latérales (11) comme masque, pour former des prolongements d'électrode de grille (10) adjacents à l'électrode de grille ; et
(h) implanter des ions (12) d'un second type de conductivité en utilisant lesdits parois latérales (11), électrode de grille (7) et prolongements d'électrode de grille (10) comme masque, appliquer ensuite un traitement thermique pour former des régions de source (13) et de drain (14), en formant ainsi sur ledit substrat une première partie de canal (P₁) comprenant des ions du premier type de conductivité et correspondant à ladite électrode de grille (7), des secondes parties de canal (P2, P3) ayant une concentration en impuretés supérieure à celle de la première partie de canal et correspondant respectivement auxdits prolongements (10) d'électrode de grille, et des régions de source et de drain (13, 14), grâce à quoi la totalité des régions de source et de drain se trouvent latéralement à l'extérieur des secondes parties de canal.

2. Procédé selon la revendication 1, dans lequel lesdits ions (5 ; 8) du premier type de conductivité sont des ions B ou des ions In.

3. Procédé selon la revendication 1, dans lequel lesdits ions (12) du second type de conductivité sont des ions P ou des ions As.

4. Procédé selon l'une quelconque des revendications 1 à 3, dans lequel la partie maintenue de ladite couche mince de polysilicium (9), qui forme le prolongement d'électrode de grille (10) a une section transversale profilée en L.

5. Dispositif semi-conducteur ayant un canal légèrement dopé de manière non uniforme comprenant :
un substrat de silicium (1) d'un premier type de conductivité ;
un film d'oxyde diélectrique de grille (6), formé sur le substrat de silicium ;
une électrode de grille (7) formée sur le film d'oxyde diélectrique de grille ;
des prolongements d'électrode de grille (10) constitués par des parties respectives de couche mince de polysilicium formée sur le film d'oxyde diélectrique de grille, sur des côtés opposés de l'électrode de grille (7), les prolongements d'électrode de grille (10) partant chacun d'un bord respectif de l'électrode de grille et étant en contact avec celui-ci, les prolongements d'électrode de grille (10) étant substantiellement plus minces que l'électrode de grille ; et
une région de canal formée dans le substrat de silicium, ladite région de canal ayant une première partie de canal (P1) située sous l'électrode de grille (7), et dopée par des ions dudit premier type de conductivité avec une concentration supérieure à celle du substrat de silicium à l'extérieur de la région de canal, et des secondes parties de canal (P2, P3) de bord situées respectivement sous les prolongements d'électrode de grille (10), et dopées par des ions dudit premier type de conductivité avec une concentration supérieure à celle de ladite première partie de canal (P1), ledit substrat de silicium (1) ayant des parties extérieures dans lesquelles des régions de source et de drain (13, 14) dopées par des ions d'un second type de conductivité sont respectivement formées, les régions de source et de drain (13, 14) étant formées en totalité latéralement à l'extérieur de la totalité des secondes parties de canal (P2, P3).

6. Dispositif semi-conducteur selon la revendication 5, dans lequel chacun des prolongements d'électrode de grille (10) a une section transversale profilée en L.
